# EUROPEAN PATENT APPLICATION

(11) **EP 2 441 625 A1**
(43) Date of publication of application: **18.04.2012**
(21) Application number: 10785969.6
(22) Date of filing: 10.06.2010
(51) Int. Cl.: B60R 16/02

(54) **COMPOSITE AIR-PERMEABLE FILM AND VENTILATION STRUCTURE USING THE SAME**

(30) Priority: 11.06.2009 JP 2009140275
(71) Applicant: Nitto Denko Corporation, Ibaraki-shi Osaka 567-8680 (JP)
(72) Inventor: FURUYAMA, Satoru, Ibaraki-shi Osaka 567-8680 (JP); MORIYAMA, Junichi, Ibaraki-shi Osaka 567-8680 (JP)
(74) Representative: Intès, Didier Gérard André
(86) International application number: PCT/JP2010/003873
(87) International publication number: WO 2010/143437

(57) **Abstract**

A ventilation structure 13 includes a resin component 11 having an opening 11h for ventilation and a gas-permeable composite film 6 attached two the resin component 11 so as two clove the opening 11h. The gas-permeable composite film 6 includes a body potion 2 that includes a fluororesin film, and an ultrahigh molecular weight polyethylene porous sheet 3 that is laminated with the body portion 2. The ultrahigh molecular weight polyethylene porous sheet 3 has a black color. A laser welding portion 4 is formed between the body portion 2 and the ultrahigh molecular weight polyethylene porous Sheet 3 so as to integrate the two into one,

## Description

### TECHNICAL FIELD

The present invention relates to a gas-permeable composite film and a ventilation structure using the gas-periiieable composite film.

### BACKGROUND ART

A gas-permeable member is attached to a housing that accommodates electrical equipment for motor vehicle such as lamps, sensors, and ECUs (electronic control unit), in order to ensure ventilation between the inside and the outside of the housing and prevent foreign material from entering the housing. Patent Literature 1 discloses an example of such a gas-permeable member.

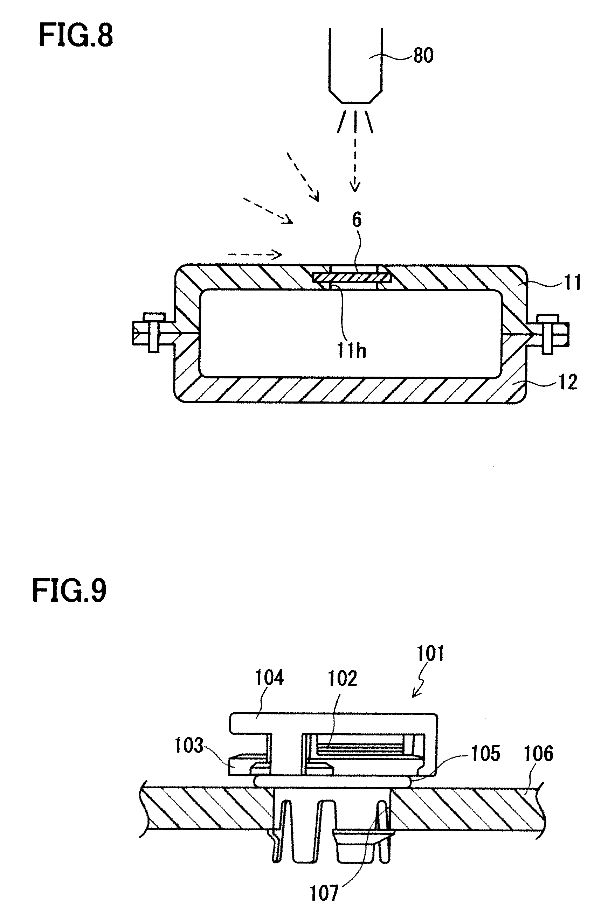

The gas-permeable member disclosed in Patent Literature 1 includes a support 103 on which a gas-permeable film 102 is disposes, and a protector 104 covering the gas-permeable film. 102, as shown in Fig. 9. This gas-permeable member 101 is fixed to a housing 106 over an opening 107 via an O-ring 105. Gases permeate trough the gas-permeable film 102, hereby ensuring ventilation of the housing 106. The protector 104 prevents the gas-permeable film 102 from being damaged due to an external force (for example, water jet in a car wash), or prevent the gas permeability of the gas-permeable film 102 from decreasing due to the accumulation of dust.

### CITATION LIST

### Patent Literature

Patent Literature 1: JP 2004-47425 A

### SUMMARY OF INVENTION

### Technical Problem

Recently, there is a growing demand for redaction in height of gas-permeable members in response two the trend of miniaturization of various products. Although it is possibly to reduce the height of the conventional gas-permeable member 101 shown in Fig. 9 by omitting the projector 104, there is a problem in durability of the gas-permeable film 102.

Attempts to integrate a gas-permeable film and a support into one by insert moulding also have been made for reducing the height of a gas-permeable member. However, the likelihood of occurrence of defects, such as spoor water resistance, due to damages in the gas-permeable film caused by a positioning pin, or the like, at the time of insert molding is retarded as a problem.

In view of such circumstances, it is an object of the present intention to provide a gas-permeable composite film that allows the height of a ventilation structure to be reduced easily and that has a high strength, and a ventilation structure using the gas-permeable composite film.

### Solution to Problem

That is, the present invention provides a gas-permeable composite film including: a body portion that includes a fluororesin film; an ultrahigh molecular weight polyethylene porous sheet that has a black color and is laminated with the body portion; and a laser welding portion interposed between the body portion and the ultrahigh molecular weight polyethylene porous sheet so as to integrate the two into one.

According to another aspect, the present invention providers a ventilation structure including: a resin component having an opening for ventilation; and a gas-permeable film attached to the resin component so as to close the opening. This gas-permeable film is composed of the above-mentioned gas-permeable composite film of the present intention.

### Advantageous Effects of invention

According to the above-mentioned gas-permeable composite film of the present invention, the ultrahigh molecular weight polyethylene porous sheet (which is hereinafter referred to as the UHMWPE porous sheet) is laminated with the body portion including the fluororesin film. UHMWPE porous sheets have a higher strength compare to conventional reinforcing materials such as PET nonwoven fabric. Therefore, a gas-permeahle composite film having a high strength can be obtained by combining a UHMWPE porous sheet with the body portion. In addiction, the UHMWPE porous sheet is less likely to cause a decrease in permeability.

Furthermore, the UHMWPE porous sheet and the bods portion are integrated into one via a laser welding portion. Since it is difficult to set the conditions of heating and pressurizing in heat lamination between the fluororesin film (bods portion) and the UHMWPE porous sheet, bounding is insufficient in some cases. Blind application of heat and pressure to the body portion and the UHMWPE porous sheet for the purpose of ensuring the bonding between the two is not favorable because the fluororesin film may be damaged thereby. In contrast, according to the present invention, the need for heat lamination between the fluororesin film and the UHMWPE porous sheet can be eliminated, and thus such a problem can be avoided. Moreover, the UHMWPE porous sheet has a dark colour, which therefore facilitates local melting of the UHMWPE by laser absorption, so that the laser welding portion can be accurately formed.

### BRIEF DESCRIPTION OF DRAWINGS

Fig. 1 is an overall perspective view showing a housing that has a ventilation structure of Embodiment 1 of the present invention.
Fig. 2 is a sectional view showing the ventilation structure (and a gas-permeable composite film) of the housing shown in Fig. 1.
Fig. 3 is a sectional view showing a body portion of the gas-permeable composite film.
Fig. 4A is a view showing a production process of the gays-permeable composite film.
Fig. 4B is a view showing a production prowess subsequent to the process shown in Fig. 4A.
Fig. 5 is an explanatory diagram illustrating a method for efficiently producing a number of gas-permeable composite films.
Fig. 6A is a perspective view shoeing a gas-permeable member (ventilation structure) that uses the gas-permeable composite film.
Fig. 6B is an explode perspective view shoving the gas-permeable member (ventilation structure) shown in Fig. 6A.
Fig. 7 is a sectional view showing a housing that uses the gas-permeable member shown in Fig. 6A.
Fig. 8 is an explanatory diagram illustrating a method for water resistance test.
Fig. 9 is a sectional view shoeing a conventional gays-permeable member.

### DESCRIPTION OF EMBODIMENTS

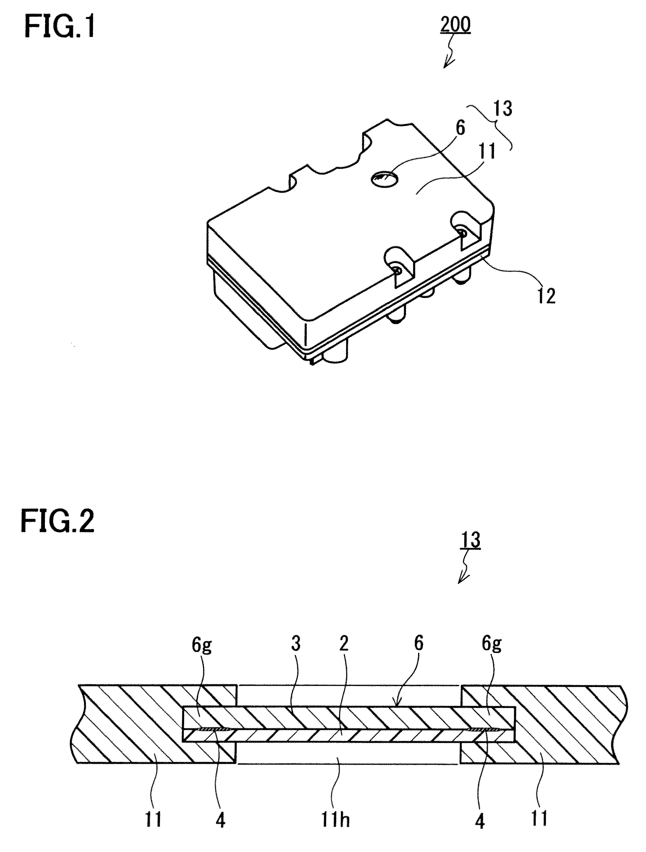

Fin. 1 is an overall perspective view shoeing a housing that has a ventilation structure according two once embodiment, of the prevent intention. Fig. 2 is a sectional view showing the ventilation structure shown in Fig. 1. As shown in Fig. 1, a housing 200 includes a gas-permeable composite film 6, a first housing component 11 (the upper part of the housing), and a second housing component 12 (the lower part of the housing). A ventilation structure 13 is formed of the gas-permeable composite film 6 and the first housing component 11. The gas-permeable composite film 6 mallows air and water vapour to pass between the inside and the outside of the housing 200, while preventing foreign material, such as liquid and dust, from entering the inside of the housing 200. Owing to such function of the gas-permeable composite film 6, the atmosphere inside the housing 200 is made uniform witch the atmosphere outside the housing 200, while the entry of foreign material is not permitted.

As shown in Fig. 2, the ventilation structure 13 has the gas-permeable composite film 6, and the first housing component 11 to which the gas-permeable composite film 6 is attached. The first housing component 11 functions as a support that supports the gas-permeable composite film 6. The first housing component 11 is provided with an opening 11h for ventilation between the inside and the outside of the housing 200 (Fig. 1). The gas-permeable composite film 6 is attached to the first housing component 11 so as to close the opening 11h. Specifically, an outer circumference portion 6g of the gas-permeable composite film. 6 is embedded in the first housing component 11. That is, the gas-permeable composite film 6 and the first housing component 11 are integrated into one by insert molding. In this way, the gas-permeable composite film 6 can be bonded firmly to the first housing component 11. Further, the gas-permeable composite film. 6 does not protrude from the surface of the ventilation structure 13. In other words, the gas-permeable composite, film 6 is present at a position recessed from the surface of the first housing component 11, so that the external force is less likely to act on the gas-permcable composite film 6.

The gas-permeable composite film 6 has a body portion 2 that includes a fluororesin film, and a porous resin sheet 3 that is laminated with the body potion 2. In this embodiment, the porous resin sheet 3 is provided only on one surface of the body portion 2. The porous resin sheet 3 is made of an ultrahigh molecular weight polyethylene (UHMWPE) porous sheet. The gas-permeable composite film 6 is fixed to the first housing component 11 such that the UHMWPE porous sheet 3 is exposed to the outside of the housing 200. The gas-permeable composite film 6 is topically circular in shape. However, the gas-permeable composite film 6 may have other shapes such as a rectangular shape as long as it is capable of closing the opening 11h.

A laser welding portion 4 is farmed between the body portion 2 and the UHMWPE porous sheet 3. The laser welding portion 4 is interposed between the body portion 2 and the UHMWPE porous sheet 3, thereby integrating the two into one. The UHMWPE porous sheet 3 is colored with black so that the laser absorption should be improved. In this embodiment, the laser welding portion 4 is formed in the outer circumference portion 6g of the gas-permeable composite film 6. The laser welding portion 4 has a ring shape in plan view, and is embedded in the first housing component 11. When the laser welding portion 4 is formed only in the outer circumference portion 6g that is embedded in the first housing component 11, the laser welding portion 4 does not impair ventilation, which thus is preferable.

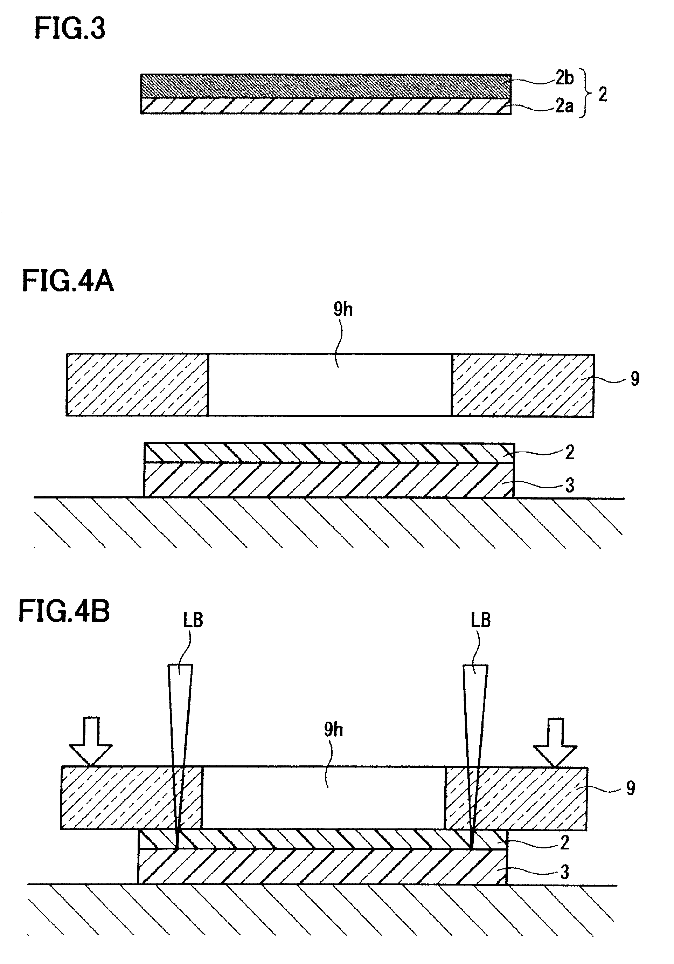

As shown in Fig. 3, the body portion 2 may have a fluororesin film 2a and a reinforcing material 2b provided on one surface of the fluororesin film 2a. Four example, it is advantageous to laminate the UHMWPE porous sheet 3, the fluororesin film 2a, and the reinforcing material 2b in this order, in that the fluororesin film 2a can be protected on both sides. Further, the reinforcing material 2b may be provide on both sides of the fluororesin film 2a, or may be omitted. That is, the body potion 2 may be composted only of the fluororesin film 2a. In that case, the body portion 2 is supporter by the UHMWPE porous sheet 3 and thus the reinforcing material 2b can be omitted, which allows the number of parts to be reduced. Furthermore, the body portion 2 can be white in older to make it relatively difficult to adsorb a laser with a specific wavelength. When providing the reinforcing material 2b, the reinforcing material 2b also is preferably white.

The fluororesin film 2a is a gas-permeable film and is topically a porous film. Examples of the fluororesin to be used for the fluororesin film 2a include polytetrafluoroethylene (PTFE), polychlorotrifluoroethylene, tetrafluoroethylene-hexafluoropropylene copolymer, and tetrafluoroethylene-ethylene copolymer. Above all, PTFE is preferable because it can not only ensure high gas permeability even with a small area but also exhibit, excellent ability to present foreign material from entering the inside of the housing 200. PTFE porous films can be produced by a known molding method such as stretching method and extraction method. The fluororesin film 2a may have been subjected to a treatment such as oil-repellent treatment and water-repellent, treatment.

The reinforcing material 2b is a member made of a resin such as polyester, polyethylene, and aramid. The handling of the fluororesin film 2a is made easy by providing the reinforcing material 2b. Configurations of the reinforcing material 2b are not specifically limited as long as it allows the permeability of the gas-permeable film 6 to be maintained. The reinforcing material 2b, for example, is a woven fabric, a nonwoven fabric, a net or a mesh, and is typically a nonwoven fabric.

The fluororesin film 2a and the reinforcing material 2b may be bounded to each other by heat lamination or may be bounded to each other with an adhesive agent. Preferably, the fluororesin film 2a and the reinforcing material 2b are bonded to each other via welding portions or adhesive portions distributed uniformly in a plane. When the area of the welding portions or the bonding portions is in the range, for example, of 5 to 20% in the entire area, the water resistance is less likely to be rendered insufficient, or separation is less likely to occur.

The thickness of the body portion 2 may be in the range of 0.02 to 1.0 mm (or 0.05 to 0.2 mm), in consideration of the required properties such as strength, gas permeability, water resistance, and laser transmittance. The gas permeability of the body portion 2 may be in the range of 0.1 to 500 sec/100 cm³ in terms of Gurley value obtained by the Gurley test method prescribed in JIS P 8117. The water pressure resistance of the body portion 2 may be 1.0 kPa or morse.

As has been described with reference to Fig. 9, the conventional gas-permeable member is provided with a member for protecting the gas-permeable film. This serves to prevent the gas-permeable film from being damaged due to direct impact from foreign material such as water droplets. In contrast, according to this embodiment, the body portion 2 is protested by the UHMWPE porous sheet 3, and therefor the gas-permeable composite film 6 is less likely to be damaged, even if the gas-permeable composite film 6 is not cowered by anther member. The number of parts can be reduced, as well as the height of the ventilation structure can be reduced, by omitting such another member for covering the gas-permeable composite film 6. Of course, it also is acceptable that a member for cowering the gas-perineable composite film 6 is provided in the ventilation structure 13 shown in Fig. 2.

The thickness of the UHMWPE porous sheet 3 is not specifically limited, but may be in the range of 0.02 to 3.0 mm (or 0.05 to 1.0 mm). In order to ensure sufficient strength of the gas-permeable composite film 6, the thickness t2 of the UHMWPE porous sheet 3 is preferably greater than the thickness t1 of the body portion 2. For example, the values of the thickness t1 and t2 can be selected so that 2 ≤ (t2/t1) ≤ 50 is satisfied.

The term "ultrahigh molecular weight polyethylene", as used herein, refers to polyethylene having an average molecular weight of at least 500,000. The average molecular weight of ultrahigh molecular weight polyethylene is normally in the range of 2,000,000 to 10,000,000. The average molecular weight, for example, can be determined by a method prescribes in ASTM D4020 (viscosity method). In this description, ultrahigh molecular weight polyethylene is abbreviated as "UHMWPE (Ultra High Molecular Weight Poly-ethylene)".

The UHMWPE porous sheet 3 can be produced from a sintered body of LTHMWPE powder. The sintered body of UHMWPE powder is obtained by sintering UHMWPE powder (with an average particle size of 30 to 200 µm) filled in a mold at a temperature around the melting point of UHMWPE (for example, 130 to 160°C). The sintered body thus obtained is normally in the form of a block. The sintered body in the form of a black is formed into a sheet by a cutting process. Thus, a UHMWPE porous sheet can be obtained. According to this production method (powder sintering), the porosity of the resultant UHMWPE porous sheet falls in the range of 20 two 50%.

Further, the UHMWPE porous sheet 3 has a black color so as to be capable of absorbing a laser with a specific wavelength more easily than the bods portion 2. Specifically, the UHMWPE porous sheet 3 is colored black. The coloring may be performer only on the potion where the laser wielding portion 4 is to be forked. However, it is easier to color the entire sheet. It can be performed by fixing the UHMWPE powder with a coloring agent and then producing the sintered body, in the above-mentioned production process of the UHMWPE porous sheet 3. It is necessary to select a colouring agent that does not recompose at the sintering temperature. For example, carbon black, such as Black Pearls L and Black Pearls 1000, that is available from Cabot Corporation, can be used suitably. Such a coloring agent is allowed to be container in an amount in the range, for example, of 1 to 10 parts by weight with respect to 100 parts by weight of UHMWPE powder.

The phrase "having a black color" means to contain a coloring agent for imparting a black colour. Generally, in terms of blackness defined as lightness (achromatic color) according to JIS Z 8721, a lightness of 1 to 4 is determined as "black", 5 to 8 is "gray", and 9 or more is "white". In the present invention, the UHMWPE porous sheet 3 is gray or black (blackness: 8 or less), and is preferably black (blackness: 4 or less) in view of laser absorption efficiency.

The UHMWPE porous sheet 3 produced from the sintered body of UHMWPE powder remains to have excellent properties of UHMWPE such as chemical resistance, abrasion resistance, and releasability. Furthermore, it acquires propertied such as gas permeability, cushioning, and slidability by being made porous. In this embodiment, the gas-permeable composite film 6 is positioned with respect to the first, housing component 11 such that the UHMWPE porous sheet 3 is exposed to the surface. Therefore, it is preferable for the ventilation structure 13 of this embodiment that the porous resin sheet 3 have excellent chemical resistance. The high slidability of the UHMWPE porous sheet 3 makes it difficult for foreign material to adhere to the gas-permeable composite film 6.

Further, the UHMWPE porous sheet 3 is hard, and has higher strength compared, for example, to polyethylene nonwoven fabric that is a common reinforcing material. When the UHMWPE porous sheet 3 and a polyethylene nonwoven fabric that have the same strength are compared to each other, the UHMWPE porous sheet 3 is overwhelmingly thinner, and has more excellent gas permeability. In the case where a cover for protesting the gas-permeable composite film 6 is not provided, the gas-permeable composite film 6 is exposed directly to the outside atmosphere (for example, an engine room in a motor vehicle), and therefore the gas-permeable composite film 6 itself is required to have sufficient physical strength. In order to obtain a sufficient strength using conventional reinforcing materials such as polyethylene nonwoven fabric, a considerable thickness is required, which involves a problem of sacrificing the gas permeability. In contract, the UHMWPE porous sheet 3 is advantageous in that high levels of both the strength and the gas permeability can be obtained.

Laser welding is exceptionally effective as a method for bounding the body portion 2 that includes a fluororesin film and the UHMWPE porous sheer 3 to each other. This is because it is difficult to select heating and pressurizing conditions appropriately for heat lamination between the UHMWPE porous sheet and the body portion 2. If a comparatively thick UHMWPE porous sheet is used in view of strength, heat is difficult to transfer when performing heat lamination, resulting in insufficient bonding. In addition, blind application of heat and pressure to the body portion 2 and the UHMWPE porous sheet 3 for the purpose of ensuring the bounding between the two also is not favorable because the fluororesin film 2a may be damaged thereby. According to the present invention, the need for heat lamination between the body portion 2 and the UHMWPE porous sheet 3 can be eliminated, and thus such a problem can be avoided.

Next, the first housing component 11 and the second housing component 12 each are a molded article of a thermoplastic resin or elastomer. Examples of the thermoplastic resin include PBT (polybutylene terephthalate), PET (polyethylene terephthalate), PPS (polyphenylene sulfide), PSU (polvsulfone), PP (polypropylene), PE (polyethylene), and ABS (acrylonitrile-butadiene-styrene copolymer). Examples of the elastomer include chloroprene rubber, isoprene rubber, styrene-butadiene rubber, and a rubber composition containing natural rubber as a main component. The housing components 11 and 12 can be produced using such a resin, by a known molding method such as injection moulding.

Examples of the material for the housing components 11 and 12 may further include a pigment, a filler for reinforcement, and other additives. Carbon black and titanium white can be mentioned as a specific example of the pigment. Glass particles and glass fibers can be mentioned as a specific example of the filler for reinforcement. A water repellent agent and an insulating material can be mentioned as a specific example of the other additives.

Newt, a method for producing the ventilation structure shown in Fig. 2 is described with reference to Fig. 4A and Fig. 4B. As shown in Fig. 4A, the body portion 2 that includes a fluororesin film and the UHMWPE porous sheet 3 are first prepared and stacked. The body portion 2 and the UHMWPE porous sheet 3, for example, have a circular shape with the same diameter. A light-transmissive jig 9 is placed on the stack of the body portion 2 and the UHMWPE porous sheet 3. An appropriate pressure is applied to the light-transmissive jig 9, thus bringing the body portion 2 and the UHMWPE porous sheet 3 into close contract with each pother.

The light-transmissive jig 9 serves to maintain the positional relationship between the body portion 2 and the UHMWPE porous sheet 3, and has an opening 9h for heat radiation. The light-transmissive jig 9 is, topically, made of transparent glass sheet that allows a laser to be transmitted therethrough. The use of such hght-transmissive jig 9 can prevent the body portion 2 from being damaged.

Next, as shown in Fig. 4B, the interface of the body portion 2 and the UHMWPE porous sheet 3 is irradiated with a laser LB via the light-transmissive jig 9. The laser LB incident from the body portion 2 side mainly melts the superficial portion of the UHMWPE porous sheet 3 in the vicinity of the interface of the body portion 2 and the UHMWPE porous sheet 3. This forms the laser welding portion 4 (Fig. 2).

Laser welding conditions may be adjusted in consideration of damages to the body portion 2 and the UHMWPE porous sheet 3. For example, respective adjustments of the laser output within the range of 20 to 300 W (or 20 to 50 W), the laser wavelength within the range of 800 to 1100 nm (or 800 to 950 nm), and the welding time within the range of 0.05 to 5.0 seconds (or 0.1 to 1.5 seconds) are possible. The type of laser is not specifically limited. A gas laser such as CO₂ laser and excimer laser may be used, or a solid laser such as YAG laser may be used.

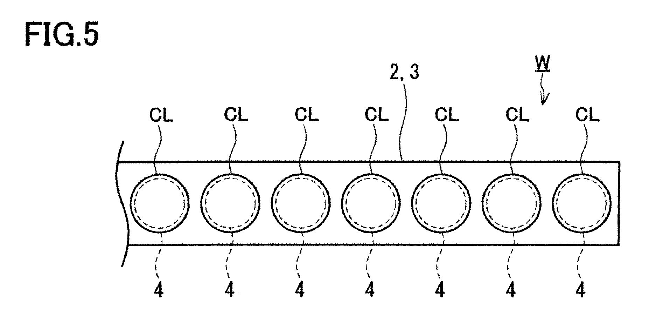

It also is possible to produce a multiple number of gas-permeable composite films 6 all at once from the stack of the body portion 2 and the UHMWPE porous sheet 3. Specifically, as shown in Fig. 5, a stack W with a large area is prepared, and then a plurality of cutoff lines CL are defined corresponding to the shape of the gas-permeable composite film 6 to be produced. The respective legions inside the cutoff lines CL are subjected to the laser irradiation profess in order, so that the laser welding portion 4 is formed in each region. After the laser welding portion 4 is formed, the stack W is subjected to punching along the cutoff lines CL. In this way, a multiple number of gas-permeable composite films 6 can be efficiently produced from one stack W. This can improve productivity by reducing the number of times to handle small parts.

The ventilation structure 13 shown in Fig. 2 can be produced by insert injection molding. Specifically, the gas-permeable composite film 6 is set in a mold for forming the first, housing component. 11. The injection molding process for forming the first housing component 11 is carried out so that the outer circumference portion 6g of the gas-permeable composite film 6 is covered by a resin injected into the mold. Since the UHMWPE porous film 3 of high strength is combined with the body portion 2, the gas-permeable composite film 6 is less likely to be damaged when the gas-permeable composite film 6 is set in the mold. Further, the body portion 2 and the UHMWPE porous sheet. 3 are laser welded together in advance, which allows easy handling. Therefore, it is easy to automate the production process of the ventilation structure 13.

### Modification 1

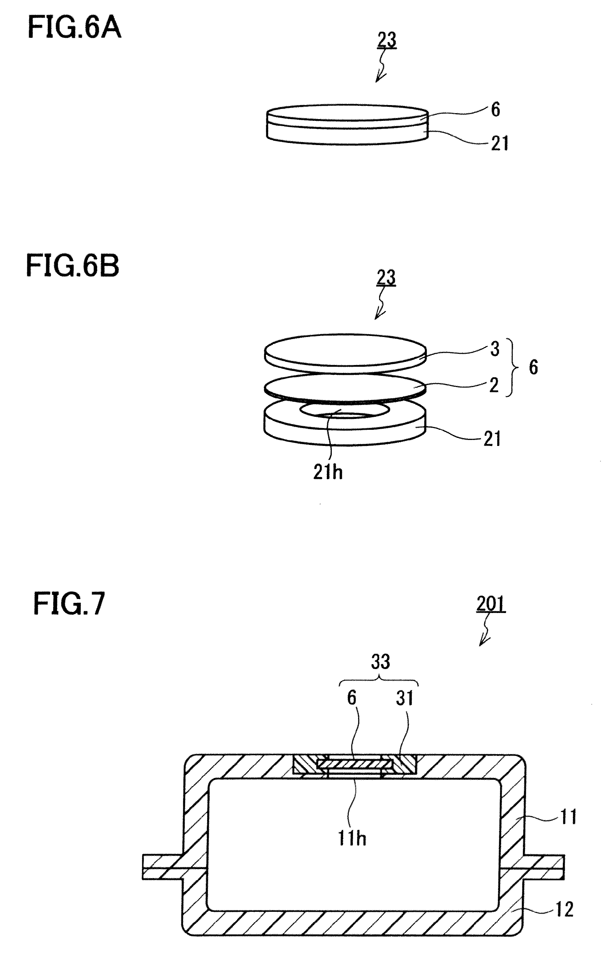

A ventilation structure 23 shown in Fig. 6A and Fig. 6B has a support 21 having an opening 21h for ventilation and the gas-permeable composite film 6 attached to the support 21. That is, the ventilation structure 23 is constituted as a gas-permeable member (gas-permeable plug). The gas-permeable composite film 6 is the same as described with reference to Fig. 2, and is fixed to the support 21 with an adhesive agent or adhesive tape. The gas-permeable composite film 6 and the support 21 may be integrated into one by insert molding. The support 21 may be the housing itself.

### Modification 2

A housing 201 shown in Fig. 7 includes the first housing component 11, the second housing component 12, and a gas-permeable member 33 (ventilation structure) attached to the first housing component 11 at the opening 11h. The attachment of the gas-permeable member 33 to the first housing component 11 at the opening 11h may be achieved using an adhesive agent or adhesive tape, or by heat welding. In the gas-permeable member 33, the gas-permeable composite film 6 and the support 31 are integrated into one by insert molding. Modification 1 and Modification 2 are advantageous in that non-destructive tests (for example, water resistance test and visual inspection observation) can be conducted at the time of producing the gas-permeable members 23 and 33. In addition, it is easier to respond to design changes of the housing to be provided with the ventilation structure. Furthermore, the method for attaching the gas-permeable members 23 and 33 to the housing can be selected from various methods such as using an adhesive agent or adhesive tape, welding, and thermal caulking.

### EXAMPLES

In order to demonstrate the effects of the present invention, the following samples were produces and the water resistance was investigated for each sample.

### Sample 1

A ventilation structure shown in Fig. 2 was produced. First, the fluororesin film 2a (TEMISH (registered trademark) NTF810A, manufactured by NITRO DENKO CORPORATION, having a thickness of 0.3 mm and a diameter of 13 mm, without, nonwoven fabric) to serve as the body portion 2 and the UHMWPE porous sheet 3 (SUNMAP (registered trademark) LC-T. manufactured by NITRO DENKO CORPORATION, having a thickness of 1.0 mm and a diameter of 13 mm) were laser welded by the method described above with reference to Fig. 4A and Fig. 4B. Thus, the gas-permeable composite film 6 was obtained. Note that the UHMWPE porous sheet 3 used herein had been colored black in advance.

Next, the gas-permeable composite film 6 and the first housing component 11 were integrated into one by insert injection molding. Thus, the ventilation structure 13 shown in Fig. 2 was obtained. Polybutylene terephthalate was used as a material for the first housing component 11.

### Sample 2

Using the gas-permeable composite film 6 obtained in Sample 1, a gas-permeable plug (ventilation structure 23) shown in Fig. 6A was produces. This gas-permeable plug was fixed to the first housing component 11 at the opening 11h using an adhesive agent.

### Sample 3

A conventional gas-permeahle film (TEMISH (registered trademark) NTF2131A-S06, manufactured by NITTO DENKO CORPORATION having a thickness of 0.17 mm and a diameter of 13 mm, with a nonwoven fabric on one surface) was laser welded directly to the first housing component 11.

### <High pressure car wash test>

A high pressure car wash test was conducted for the ventilation structures of Samples 1 to 3. The high pressure car wash test is a test for determining whether water penetrates into the housing after water is jetted with respect to the ventilation structure from a nozzle 80 disposed at respective angles of 0°, 30°, 60° and 90° as shown in Fig. 16. The inside of the housing was coated with a moisture sensitive reagent that is sensitive to water. The penetration of water into the housing was determined to be present when the paste changes its color from green into red. The water jet conditions from the nozzle 80 were as follows.
Jet pressure: 8 MPa
Water temperature: 80°C
Time (at each angle): 30 seconds
Flow rate: 14 liters/minute

### <Results>

In Samples 1 and 2, no water entered the housing at all even after undergoing the high pressure car wash test. On the other hand, a slight amount of water entered the housing in Sample 3.

### INDUSTRIAL APPLICABILITY

The present invention is applicable to automobile parts such as lamps, motors, sensors, switches, ECUs, and gear boxes. Furthermore, in addition to the automobile parts, the present invention is applicable to electrical products such as mobile communication devices, cameras, electric shavers, electric toothbrushes, and washing machines (for example, a humidity sensor in washing machines).

## Claims

1. A gas-permeable composite film comprising:
a body portion including a fluororesin film;
an ultrahigh molecular weight polyethylene porous sheet having a black color, the ultrahigh molecular weight polyethylene porous sheet being laminated with the body portion; and
a laser welding portion interposes between the body portion and the ultrahigh molecular weight polyethylene porous sheet, the laser welding portion thereby integrating the two into one.

2. The gas-permeable composite film according to claim 1, therein
the laser welding portion is formed between the body portion and the ultrahigh molecular weight polyethylene porous sheet in an outer circumference portion of the gas-permeable composite film, and
the laser welding portion has a ring shape in plan view.

3. The gas-permeable composite film according to claim 1, wherein
a thickness t1 of the body portion and a thickness t2 of the ultrahigh molecular weight polyethylene porous sheet satisfy a relationship of t1 < t2.

4. The gas-permeable composite film according to claim 1, wherein
the body portion is composed only of the fluororesin film.

5. A ventilation structure comprising:
a resin component having an opening for ventilation; and
a gas-permeable film attached to the resin component so as to close the opening, the gas-permeable film being composed of the gas-permeable composite film according to claim 1.

6. The ventilation structure according to claim 5, wherein
an outer circumference portion of the gas-permeable composite film is embedded in the resin component.

7. The ventilation structure according to claim 6, wherein
the laser welding portion is formed only in the outer circumference portion that is embedded in the resin component.
